# EUROPEAN PATENT APPLICATION

(11) **EP 1 901 347 A2**
(43) Date of publication of application: **19.03.2008**
(21) Application number: 07252613.0
(22) Date of filing: 27.06.2007
(51) Int. Cl.: H01L 21/84, H01L 21/20

(54) **Method for crystallizing semiconductor film and semiconductor film crystallized by the method**

(30) Priority: 15.09.2006 US 521996
(71) Applicant: Sharp Kabushiki Kaisha, Osaka-shi, Osaka 545-8522 (JP)
(72) Inventor: Crowder, Mark, Portland OR 97212 (US); Voutsas, Apostolos T., Portland OR 97229 (US)
(74) Representative: Brown, Kenneth Richard

(57) **Abstract**

A method is provided for crystallizing a semiconductor film using a buried seed one-shot interlevel crystallization process. The method forms on a transparent substrate, a first semiconductor film having a crystallographic structure, an insulator layer with an opening, which exposes a portion of a first semiconductor film top surface in this order, and then forms a second semiconductor film with an amorphous structure in this order. The second semiconductor film is laser annealed so that the second semiconductor film is completely melted and the first semiconductor film is partially melted. Using unmelted first semiconductor film as a seed, the second semiconductor film is crystallized.

## Description

### FIELD OF THE INVENTION

This invention generally relates to integrated circuit (IC) fabrication and, more particularly, to a dual-gate thin-film transistor (DG-TFT) fabricated process using a buried seed interlevel crystallization method.

### BACKGROUND OF THE INVENTION

For hybrid continuous grain silicon (CGS) processing of silicon (Si) thin-films for TFT applications, the "1-shot" process is a high-throughput scheme that can provide location control of the grain boundaries in the crystalline film.

A laser pulse is typical referred to as a "shot", and a 1-shot process uses a single laser pulse to anneal a film. There are two main implementations of this approach that affect the resulting microstructure, either pre-patterning the Si islands prior to crystallization, or not. In either case, the location control is induced by fully melting the Si film in all areas except where a pre-positioned seed is desired, to begin the crystallization of the supercooled melt.

Typically, this seed is placed by first encapsulating the Si layer (either pre-patterned or non-patterned) with a 500 Å SiO₂ cap layer, depositing a sufficiently thick Si layer (approximately 2,000 Å), and then patterning the Si layer to leave behind dots or lines that will shadow the Excimer laser radiation from the underlying Si active layer.

The dots or lines have to be large enough to keep a sufficiently wide region of the Si underlayer from being irradiated, in order to account for lateral heat diffusion. Typical widths are on the order of 3-4 microns (µm). When the surrounding molten Si begins to cool below the equilibrium temperature, the seed initiates lateral growth into the surrounding regions.

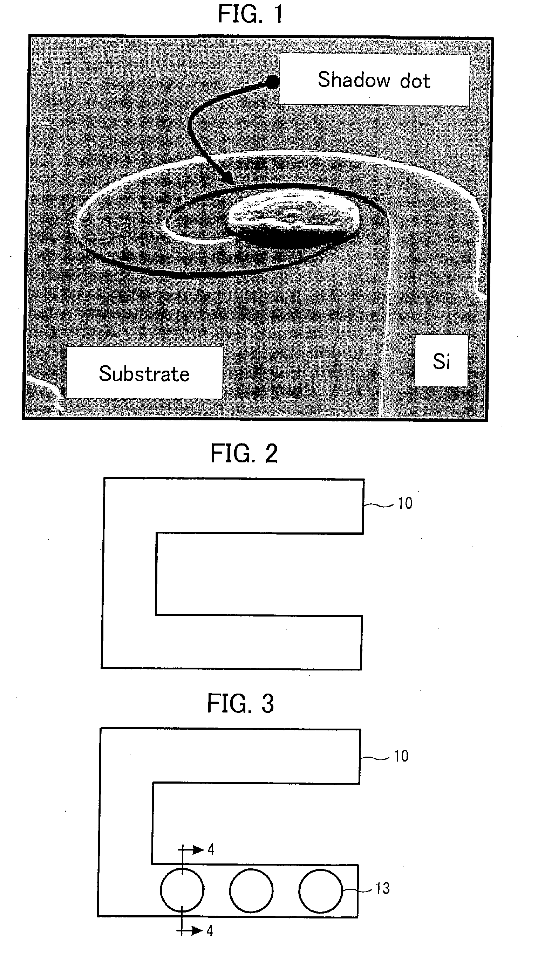

Fig. 1 is a perspective drawing depicting a pre-patterned Si active layer with a shadow Si layer (dot) for a "1-shot" location control crystallization scheme (prior art). Fig. 1 shows a 70° tilted sample with a pre-patterned Si island and a cap Si layer to induce lateral growth. Upon irradiation, the seed initiates growth from under the shadow dot and lateral growth then proceeds around the spiral and into the remainder of the Si island.

In many embodiments of the above-described approach, the dot must eventually be removed, which can be problematic for subsequent TFT fabrication steps (e.g., implantation, contact hole formation, and planarity). Removal of the dot requires either a controlled dry etch of the Si shadow layer, a wet etch in TMAH, or (for non-patterned Si active layers) an etch in dilute HF to undercut the lines and dots and cause them to lift off.

A better approach would be to seed the lateral growth via (via contact hole) a means that can be left in place following the crystallization and that will not interfere with subsequent processing steps.

### SUMMARY OF THE INVENTION

A "1-shot" location control crystallization scheme can be enhanced if a predetermined region of the Si active layer can be left in contact with an area of solid (i.e., non-melted) Si that can act as a seed for lateral growth. For a variety of reasons, including better compatibility with 3D architectures and improved throughput, it is desirable to crystallize greater areas with a single shot. The conventional directional solidification approach is no longer sufficient for current designs which utilize the co-integration of various 3D architectures (e.g., back-gate, planar, and dual-gate TFTs). To better enable the crystallization of 3D structures, the present invention uses the back-gate as a means to seed the lateral growth and control the placement of the grain boundaries relative to the active channel of the TFTs.

Accordingly, a method is provided for crystallizing a semiconductor film using a buried seed one-shot interlevel crystallization process. The method forms a first semiconductor film having a crystallographic structure, overlying a transparent substrate. An insulator layer is formed overlying the first semiconductor film, and an opening is formed in the insulator layer, which exposes a portion of a first semiconductor film top surface. Then, a second semiconductor film with an amorphous structure is formed overlying the insulator layer. Typically, the first and second semiconductor films are Si, and the insulator layer is often an oxide or nitride. The second semiconductor film is laser annealed. In one aspect, the annealing is accomplished with a single laser shot. In response to the laser annealing, the second semiconductor film is completely melted and the first semiconductor film is partially melted. Using unmelted first semiconductor film as a seed, the second semiconductor film is crystallized.

One aspect of the method includes preheating the substrate with at least one laser fluence pulse F (J/cm²· pulse), from a first laser source, prior to melting the second semiconductor film with at least one laser fluence pulse from a second laser source.

In one application, the first semiconductor film forms a bottom gate overlying the substrate, the insulator layer forms a bottom gate dielectric, and the second semiconductor layer forms an active Si layer. More specifically, the bottom gate has a first portion and a second portion, and a via (via contact hole) is formed in the gate dielectric overlying the bottom gate first portion. The bottom gate first portion is partially melted by the annealing, and the bottom gate second portion is used as the seed for crystallizing the active Si layer.

Additional details of the above-described methods are provided below.

Additional objects, features, and strengths of the present invention will be made clear by the description below. Further, the advantages of the present invention will be evident from the following explanation in reference to the drawings.

### BRIEF DESCRIPTION OF THE SEVERAL DRAWINGS

Fig. 1 is a perspective drawing depicting a pre-patterned Si active layer with a shadow Si layer (dot) for a "1-shot" location control crystallization scheme (prior art).
Fig. 2 which explains steps in the crystallization of a dual-gate TFT (DG-TFT) using a buried seed one-shot laser annealing process, is a plan view of a bottom gate.
Fig. 3 which explains steps in the crystallization of a dual-gate TFT (DG-TFT) using a buried seed one-shot laser annealing process, is the bottom gate of Fig. 2 following the formation of vias.
Fig. 4 which explains steps in the crystallization of a dual-gate TFT (DG-TFT) using a buried seed one-shot laser annealing process, is partial cross-sectional view of the bottom gate of Fig. 3.
Fig. 5 which explains steps in the crystallization of a dual-gate TFT (DG-TFT) using a buried seed one-shot laser annealing process, is a plan view of the active Si layer 12 following crystallization.
Fig. 6 which explains steps in the crystallization of a dual-gate TFT (DG-TFT) using a buried seed one-shot laser annealing process, is a plan view depicting the active Si layer after being patterned.
Fig. 7 which explains steps in the crystallization of a dual-gate TFT (DG-TFT) using a buried seed one-shot laser annealing process is a plan view showing the final discrete device layout.
Fig. 8 is a flowchart illustrating a method for crystallizing a semiconductor film using a buried seed one-shot interlevel crystallization process.
Fig. 9 is a flowchart illustrating a DG-TFT fabrication method for seeding the crystallization of an active Si layer using vias to an underlying bottom gate.

### DETAILED DESCRIPTION OF EXEMPLARY EMBODIMENTS

Embodiments of the present invention will be best understood by reference to the drawings, wherein like parts are designated by like numerals throughout. The figures listed above are expressly incorporated as part of this detailed description.

A "1-shot" location control crystallization scheme relies a predetermined region of the Si active layer being left in contact with a (non-melted) single-crystal region that acts as a seed for lateral growth. The crystallization of 3D structures in back-gate, planar, and dual-gate TFTs architectures is improved with the use of 1-shot laser annealing processes. An example is provided, below, of a back-gate that is used to seed the lateral growth and control the placement of the grain boundaries relative to the active channel of the TFTs.

Figs. 2 through 7 depict steps in the crystallization of a dual-gate TFT (DG-TFT) using a buried seed one-shot laser annealing process. Generally, a DG-TFT is a transistor with a bottom gate or back-gate, underlying a planar TFT structure, which includes source and drain regions, a channel, and a top gate. The back-gate is used to control the threshold voltage of the overlying planar TFT. Additional details of a DG-TFT can be found in a pending application entitled, DUAL-GATE TRANSISTOR DISPLAY, invented by Afentakis et al., Serial No. 11/184,699, filed July 18, 2005, which is incorporated herein by reference (Docket No. SLA8010).

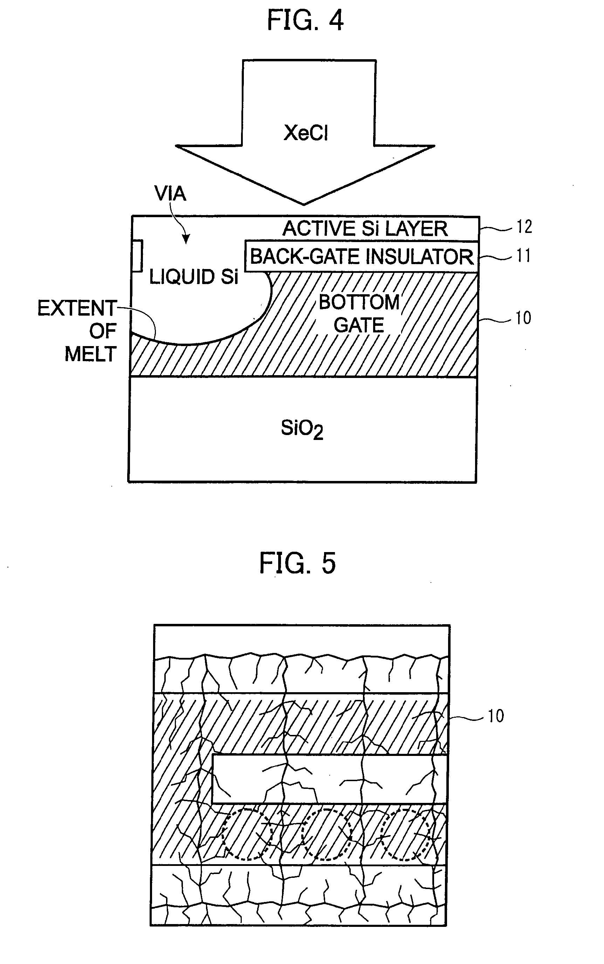

Fig. 2 is a plan view of a bottom gate (back-gate) 10. The bottom gate 10 is doped, patterned, and then capped with a back-gate insulator 11 as shown in Fig. 4. Typically, the bottom gate 10 is polycrystalline, or it may even have a single-crystal structure.

Fig. 3 is the bottom gate 10 of Fig. 2 following the formation of via contact holes (vias) 13, which have been opened through the back-gate insulator 11, to the bottom gate 10. An amorphous Si (a-Si) active layer 12 is then deposited over back-gate insulator 11, making contact with the bottom gate 10 through the via contact holes 13.

Fig. 4 is a partial cross-sectional view of the bottom gate 10 of Fig. 3. A majority, if not all, of Excimer fluence (represented by the arrow labeled "XeCl") is absorbed by the active Si layer 12. A typical active Si layer 12 may have a thickness on the order of 500 Å. Thermal conduction leads to the melt front extending through the via contact holes 13 and partially melting the buried bottom gate electrode 10. The thermal mass of the bottom gate electrode 10 may be of the order of four times the active Si layer thickness, resulting in a significant portion of the bottom gate remain solid. Upon cooling, vertical regrowth of solid material extends through the via contact hole 13, seeding LC (location controlled) lateral growth.

Fig. 5 is a plan view of the active Si layer 12 following crystallization. The crystalline microstructure may be tailored to particular applications, for example, controlling the location of the grain boundaries relative to the active channel region of the TFTs. Fig. 5 shows circular regions in the center of crystal grains, where lateral growth has been initiated by seeds left in contact with molten Si. The relative position of bottom gate 10 is shown in cross-hatch.

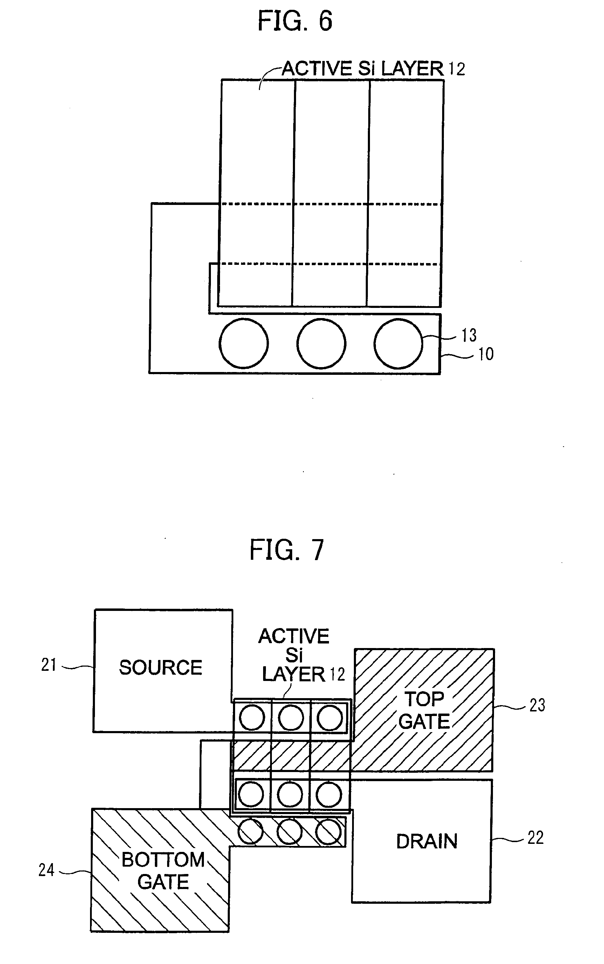

Fig. 6 is a plan view depicting the active Si layer 12 after it has been patterned for use as the active channel of a TFT. Crystallization is carried out prior to patterning. Because the buried bottom gate electrode 10 is covered with the active Si layer 12, it is not been melted during irradiation. Patterning the active region breaks the (Si) contact with the active channel and the buried bottom gate electrode.

Fig. 7 is a plan view showing the final discrete device layout with 4 pads for contact to the source 21, the drain 22, the top gate 23, and the back-gate 24. Devices may also be fabricated using the above-described approach without either the top or bottom gates (23, 24), to provide planar or back-gate TFTs, in addition to the dual-gate TFT. More generally, the method is applicable to the crystallization of vertical structures using a "1-shot" non-pre-patterned location control crystallization scheme.

### Functional Description

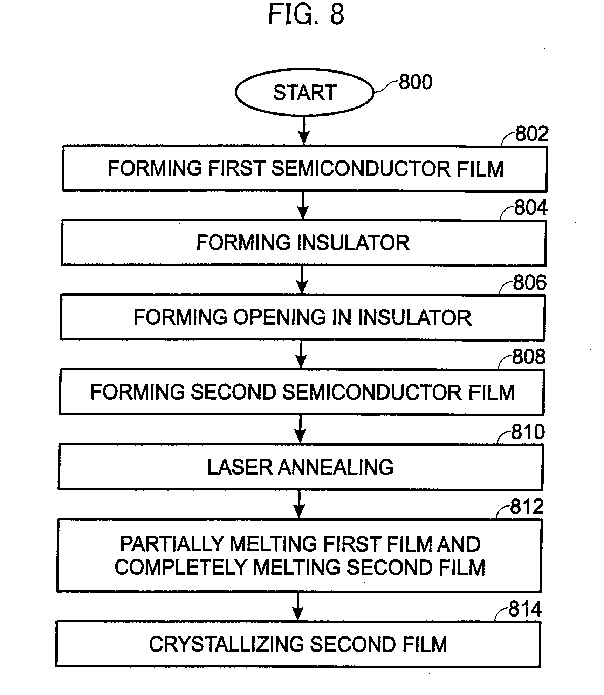

Fig. 8 is a flowchart illustrating a method for crystallizing a semiconductor film using a buried seed one-shot interlevel crystallization process in accordance with one embodiment of the present invention.

Although the method is depicted as a sequence of numbered steps for clarity, the numbering does not necessarily dictate the order of the steps. It should be understood that some of these steps may be skipped, performed in parallel, or performed without the requirement of maintaining a strict order of sequence. The method starts at Step 800.

In Step 802, a first semiconductor film having a crystallographic structure, is formed overlying a transparent substrate. For the material of the transparent substrate, for example, glass, plastic, or quartz may be adopted. Although the method can be used with any substrate material, laser annealing processes are commonly associated with these temperature-sensitive materials. In Step 804, an insulator layer is formed overlying the first semiconductor film. In Step 806, an opening is formed in the insulator layer, exposing a portion of a first semiconductor film top surface. In Step 808, a. second semiconductor film of an amorphous structure is formed overlying the insulator layer. In Step 810, the laser annealing of the second semiconductor film is carried out. In response to the laser annealing process in Step 810, the second semiconductor film is completely melted, and the first semiconductor film is partially melted in S812. Using unmelted first semiconductor film as a seed, the second semiconductor film is crystallized in S814.

In one aspect, the process of forming the opening in the insulator layer in Step 804 includes the process of forming an opening in a first location. Then, the crystallization of the second semiconductor film in Step 814 is carried out by controlling the grain boundaries of the crystallized second semiconductor film in response to the position of the first location. Returning briefly to Figs. 5 and 6, it can be seen that the crystal grain boundaries formed in the Si active layer 12 are positioned and formed with respect to the locations of the via contact holes 13 in the gate dielectric 10.

In one aspect, the process of laser annealing the second semiconductor film in Step 810 includes the process of preheating the substrate with at least one laser fluence pulse from a first laser source, prior to melting the second semiconductor film with at least one laser fluence pulse from a second laser source. For example, the substrate may be preheated with a carbon dioxide laser (CDL) pulse having a duration in a range of about 10 microseconds to 1 millisecond, and a repetition rate in a range of about 100 Hz to 50 KHz.

In another aspect, the process of melting the second semiconductor film in Step 812 includes the process of laser annealing the second semiconductor film with a single Excimer laser pulse. For example, the process of laser annealing the second semiconductor film with the single Excimer laser pulse may be carried out using a pulse duration in a range of about 30 nanoseconds (ns) to 300 ns.

The CO₂ laser fires first, to preheat the underlying SiO₂ substrate. At the end of the CDL pulse (typically 10 µs to 1 ms in length), the Excimer laser is fired such that the Si thin film directly above the preheated spot on the substrate is melted. These operations permit very localized heating of the material, to temperatures in excess of 900 °C to 1,000 °C. This high local temperature, in turn, permits very long lateral growth lengths, in excess of 30 to 100 µm depending on the conditions. The process is called a "1-shot" process due to its ability to crystallize the entire Si film, which would make up an active portion of a device, in a single shot. The seeding structure is arranged to provide an optimal microstructure that is tailored to a particular active channel orientation, size, or other desired characteristic. Of course, the term "1-shot" only refers to the Excimer laser. The CO₂ laser can fire multiple times for each Excimer laser pulse. The CDL can operate at frequencies up to 1 0s of kHz, and for some conditions this is the typical operating condition. Additional details of this process can be found in US Patent 7,018,468, which is incorporated herein by reference.

Alternate preheating sources include a UV laser, such as an Excimer laser or frequency-tripled solid-state laser, or a visible laser, such as a frequency-doubled solid-state laser, as a laser annealing source. A XeCl laser at 308 nm or a KrF laser at 243 nm are possible candidates for the Excimer laser. Frequency-tripled solid-state lasers, such as tripled Nd-YAG lasers or tripled Nd-YVO4 lasers, are also possible candidates for the UV laser. Frequency-doubled solid-state lasers, such as doubled Nd-YAG lasers operating at 532 nm or doubled Nd-YVO4 lasers, are possible candidates for the visible laser.

In a different aspect, forming the first and second semiconductor films in Steps 802 and 808, respectively, includes forming first and second semiconductor films including Si. For example, films of (pure) Si and SiGe may be used, although the process likely has application to a broader range of thin-film process materials. The insulator layer formed in Step 804 is typically an oxide film, such as silicon dioxide, a nitride film, such as silicon nitride, an oxynitride, or even a high-k dielectric material.

In one aspect, the process of forming the first semiconductor film in Step 802 includes the process of forming a bottom gate overlying the substrate, followed by the process of forming a bottom gate dielectric in Step 804. The process of forming the second semiconductor layer in Step 808 includes the process of forming an active Si layer. In one aspect, the active Si layer formed in Step 808 has a thickness in a range of about 500 Å to 1,500 Å.

More specifically, the process of forming the bottom gate in Step 802 includes the process of forming a bottom gate with a first portion and a second portion. In Step 806, a via contact hole is formed in the gate dielectric overlying the bottom gate first portion. Then, the process of partially melting the first semiconductor film in Step 812 includes the process of melting the bottom gate first portion. The process to be carried out using unmelted first semiconductor film as a seed in Step 814 includes the process to be carried out using the bottom gate second portion as the seed for crystallizing the active Si layer.

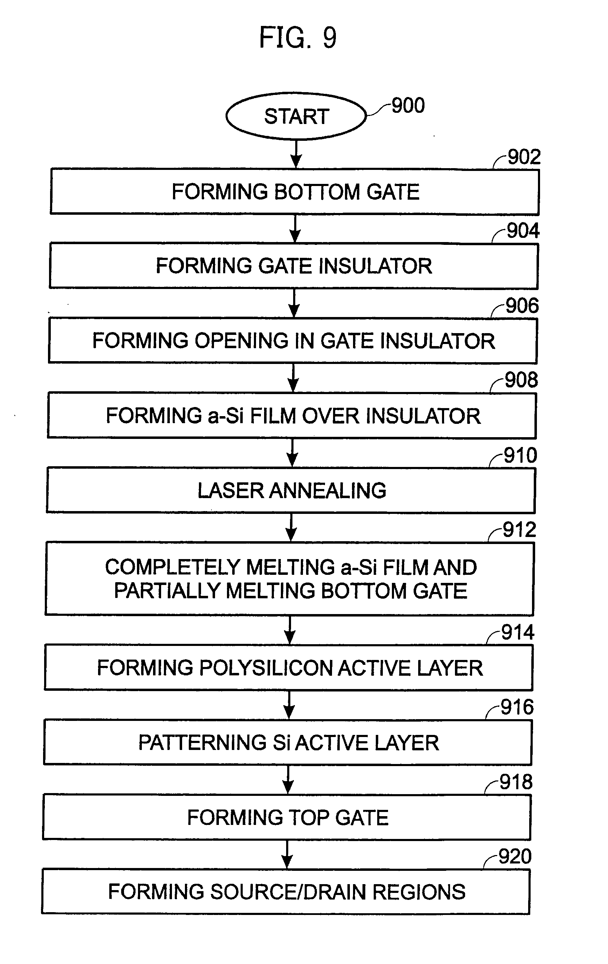

Subsequent to the process of crystallizing the active Si layer, the active Si layer is patterned to remove the active Si layer overlying via contact holes in the gate dielectric in Step 816. Then, in Step 818, a top gate is formed overlying the active Si layer, and in Step 820, source/drain (S/D) regions are formed in the active Si layer. These Steps 816 through 820, associated with the DG-TFT fabrication process are not shown in this figure, since Fig. 9 is specifically dedicated to the DG-TFT process.

In one aspect, the process of crystallizing the second semiconductor film includes the process of laterally growing a crystal grain in the second semiconductor film having a length in the range of about 20 micrometers (µm) to 30 µm. With respect to the DG-TFT, the distance from the via contact hole to the unmelted portion of the bottom gate is typically less than the crystal grain length. The crystallographic orientation of the laterally grown grains can change or break down after a semi-characteristic length (about 15 µm for a 50 nm-thick Si film), and any benefits derived from controlling the orientation of the seed (i.e., placement near the via contact hole) are diminished.

Fig. 9 is a flowchart illustrating a DG-TFT fabrication method for seeding the crystallization of an active Si layer using via contact holes to an underlying bottom gate. The method starts at Step 900. In Step 902, a Si bottom gate having a polycrystalline structure is formed, overlying a transparent substrate. In Step 904, an insulator layer is formed overlying the bottom gate. For example, an oxide or nitride insulator can be used. In Step 906, an opening is formed in the insulator layer, exposing a portion of a bottom gate top surface. In Step 908, an amorphous Si film is formed overlying the insulator layer. In Step 910, the process of laser annealing of the amorphous Si film is carried out. In response to the laser annealing process of Step 910, the amorphous Si film is completely melted and the bottom gate is partially melted in S912. Using an unmelted bottom gate polycrystalline structure as a seed, a polycrystalline Si active layer is formed in S914.

In one aspect, the substrate is preheated in S910 with at least one laser fluence pulse from a first laser source, prior to melting the amorphous Si film with at least one laser fluence pulse from a second laser source. In another aspect, the laser annealing process is carried out in S910 with a single Excimer laser pulse.

In a different aspect, a bottom gate is formed in Step 902 with a first portion and a second portion, and in Step 904, a via contact hole is formed in a gate dielectric overlying the bottom gate first portion. Then, the bottom gate first portion is melted in S914, and in Step 914, the bottom gate second portion is used as the seed for crystallizing the active Si layer.

Subsequent to the process of forming the polycrystalline active Si layer, the active Si layer is patterned in 5916 to remove the active Si layer overlying via contact holes in the gate dielectric. In Step 918, a top gate is formed overlying the active Si layer. In Step 920, source/drain (S/D) regions are formed in the active Si layer.

Methods have been provided for using a buried seed to crystallize a semiconductor film. Process details, materials, and a DG-TFT structure have been used as examples to illustrate the invention. However, the invention is not limited to merely these examples. Other variations and embodiments of the invention will occur to those skilled in the art.

The terms and expressions which have been employed in the foregoing specification are used therein as terms of description and not of limitation, and there is no intention in the use of such terms and expressions of excluding equivalence of the features shown and described or portions thereof, it being recognized that the scope of the invention is defined and limited only by the claims which follow.

## Claims

1. A method for crystallizing a semiconductor film using a buried seed one-shot interlevel crystallization process, the method comprising the steps of:
forming a first semiconductor film having a crystallographic structure, overlying a transparent substrate;
forming an insulator layer overlying the first semiconductor film;
forming an opening in the insulator layer, exposing a portion of a top surface of the first semiconductor film;
forming a second semiconductor film with an amorphous structure, overlying the insulator layer;
laser annealing the second semiconductor film;
in response to the step of laser annealing, completely melting the second semiconductor film and partially melting the first semiconductor film; and,
crystallizing the second semiconductor film using an unmelted first semiconductor film as a seed.

2. The method of claim 1 wherein:
the step of laser annealing the second semiconductor film includes the process of preheating the transparent substrate with at least one laser fluence pulse from a first laser source, prior to melting the second semiconductor film with at least one laser fluence pulse from a second laser source.

3. The method of claim 2 wherein:
the process of preheating the substrate includes a process of preheating the substrate with a carbon dioxide laser (CDL) pulse having a duration in a range of about 10 microseconds to 1 millisecond, and a repetition rate in a range of about 100 Hz to 50 KHz.

4. The method of claim 2 wherein:
the step of melting the second semiconductor film includes the process of laser annealing the second semiconductor film with a single Excimer laser pulse.

5. The method of claim 4 wherein:
the step of laser annealing the second semiconductor film with the single Excimer laser pulse is carried out using a pulse duration in a range of about 30 nanoseconds (ns) to 300 ns.

6. The method of claim 1 wherein:
silicon (Si) is used for the material of the first and second semiconductor films; and
the step of forming the insulator layer includes the process of forming an insulator from a material selected from a group consisting of oxide films and nitride films.

7. The method of claim 1 wherein:
said step of forming the opening in the insulator layer includes the process of forming an opening in a first location; and,
the step of crystallizing the second semiconductor film is carried out by controlling the grain boundaries of the crystallized second semiconductor film in response to the position of the first location.

8. The method of claim 1 wherein:
the step of forming the first semiconductor film includes a process of forming a bottom gate overlying the substrate;
the step of forming the insulator layer includes the process of forming a bottom gate dielectric; and
the step of forming the second semiconductor layer includes a process of forming an active Si layer.

9. The method of claim 8 wherein:
the step of forming the bottom gate includes a process of forming a bottom gate with a first portion and a second portion;
the step of forming the opening in the insulator layer includes a process of forming a via in the gate dielectric overlying the bottom gate first portion;
the step of partially melting the first semiconductor film includes a process of melting the bottom gate first portion; and
said step of crystallizing the second semiconductor film using unmelted first semiconductor film as a seed is carried out using the bottom gate second portion as the seed for crystallizing the active Si layer.

10. The method of claim 8 wherein:
the active Si layer is formed with a thickness in a range of about 500 Å to 1,500 Å.

11. The method of claim 9 further comprising the step of:
subsequent to crystallizing the active Si layer, patterning the active Si layer to remove the active Si layer overlying vias in the gate dielectric.

12. The method of claim 11 further comprising the steps of:
forming a top gate overlying the active Si layer; and
forming source/drain (S/D) regions in the active Si layer.

13. The method of claim 8 wherein:
the bottom gate overlying the transparent substrate is formed using a material selected from a group consisting of glass, plastic, and quartz.

14. The method of claim 8 wherein:
the step of crystallizing the second semiconductor film includes a process of laterally growing a crystal grain in the second semiconductor film having a length in the range of about 20 micrometers (µm) to 30 µm.

15. A method for seeding the crystallization of an active silicon (Si) layer using vias to an underlying bottom gate in a dual-gate thin-film transistor (DG-TFT), the method comprising the steps of:
forming a Si bottom gate with a polycrystalline structure, overlying a transparent substrate;
forming an insulator layer overlying the bottom gate;
forming an opening in the insulator layer, exposing a portion of a bottom gate top surface;
forming an amorphous Si film overlying the insulator layer;
laser annealing the amorphous Si film;
in response to the laser annealing, completely melting the amorphous Si film and partially melting the bottom gate; and,
forming a polycrystalline Si active layer using an unmelted bottom gate polycrystalline structure as a seed.

16. The method of claim 15 wherein:
the step of laser annealing the amorphous Si film includes a process of preheating the substrate with at least one laser fluence pulse from a first laser source, prior to melting the amorphous Si film with at least one laser fluence pulse from a second laser source.

17. The method of claim 15 wherein:
the step of laser annealing the amorphous Si film is carried out with a single Excimer laser pulse.

18. The method of claim 15 wherein:
the step of forming the insulator layer includes a process of forming a gate insulator from a material selected from a group consisting of an oxide film and a nitride film.

19. The method of claim 15 wherein:
the step of forming the bottom gate includes a process of forming a bottom gate with a first portion and a second portion;
the step of forming the opening in the insulator layer includes a process of forming a via in a gate dielectric overlying the bottom gate first portion;
the step of partially melting the bottom gate includes a process of melting the bottom gate first portion; and
the step to be carried out using an unmelted bottom gate polycrystalline structure as a seed includes a process to be carried out using the bottom gate second portion as the seed for crystallizing the active Si layer.

20. The method of claim 19, further comprising the steps of:
subsequent to the step of forming the polycrystalline active Si layer, patterning the active Si layer to remove the active Si layer overlying vias in the gate dielectric;
forming a top gate overlying the active Si layer; and
forming source/drain (S/D) regions in the active Si layer.

21. A semiconductor film crystallized by the method as claimed in any one of claims 1 to 20.
